# EUROPEAN PATENT APPLICATION

(11) **EP 3 288 064 A1**
(43) Date of publication of application: **28.02.2018**
(21) Application number: 17185162.9
(22) Date of filing: 07.08.2017
(51) Int. Cl.: H01L 21/768

(54) **SEMICONDUCTOR STRUCTURE AND FABRICATION METHOD THEREOF**

(30) Priority: 12.08.2016 CN 201610664298
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: ZHANG, Chenglong, Shanghai, 201203 (CN); ZHENG, Zhe, Shanghai, 201203 (CN); ZHANG, Haiyang, Shanghai, 201203 (CN)
(74) Representative: Klunker IP Patentanwälte PartG mbB

(57) **Abstract**

Semiconductor structures and fabrication methods are provided. An exemplary fabrication method includes providing a base substrate; forming gate structures over the base substrate; forming source/drain doping regions in the base substrate at two sides of each of the gate structures; forming an interlayer dielectric layer over the base substrate and the source/drain doping regions; forming a mask layer having a plurality of first openings there-through and over the interlayer dielectric layer, the first opening having a first length; performing a surface treatment process to remove portions of the mask layer from the first openings and to increase the first length of the first openings; forming contact through holes passing through the interlayer dielectric layer and exposing the source/drain doping regions using the mask layer with the first openings having the increased first length as an etching mask; and forming a contact via in each of the contact through holes.

## Description

### CROSS-REFERENCES TO RELATED APPLICATIONS

This application claims the priority of Chinese patent application No. 201610664298.5, filed on August 12, 2016.

### FIELD OF THE DISCLOSURE

The present invention generally relates to the field of semiconductor technologies and, more particularly, relates to semiconductor structures and fabrication methods thereof.

### BACKGROUND

The manufacturing of integrated circuits (ICs) requires a plurality of metal layers used to connect semiconductor devices together to form circuits. Specifically, the metal layers include interconnect lines and contact vias formed in contact through holes. The contact vias in the contact through holes connect the semiconductor devices with one another; and the interconnect lines connect the contact vias on the semiconductor devices at different layers together to form the circuits.

The process for forming the contact through holes includes providing a substrate having a first region and an adjacent second region; forming gate structures on the substrate in the first region and the second region; forming first source/drain doping regions in the substrate at two sides of each of the gate structures in the first region, and second source/drain doping regions in the substrate at two sides of each of the gate structures in the second region; forming a dielectric layer over the substrate to cover the first source/drain doping regions and the second source/drain doping regions; forming a mask material layer on the dielectric layer; forming a patterned photoresist layer on the mask material layer; forming a patterned mask layer by etching the mask material layer using the patterned photoresist layer as an etching mask; forming first contact through holes passing through the dielectric layer and exposing the first source/drain doping regions in the first region and second contact through holes passing through the dielectric layer and exposing the second source/drain doping regions in the second region by etching the dielectric layer using the patterned mask layer as an etching mask; and forming a first conductive via in each first contact through hole and a second conductive via in each second contact through hole.

However, the contact through holes formed by the existing fabrication methods may deteriorate the performance of the semiconductor structures.

### BRIEF SUMMARY OF THE DISCLOSURE

It is an object oft he present invention to provide a semiconductor structure and method for fabricating the same, which may to solve one or more problems set forth above and other problems in the art, in particular wherein contact through holes are improved so that deterioration of the performance of the resulting semiconductor structure can be avoided.

The object is achieved by the features of the respective independent claims. Further embodiments are defined in the respective dependent claims.

A first aspect of the present invention provides a method for fabricating a semiconductor structure.

The method includes providing a base substrate; forming gate structures over the base substrate; forming source/drain doping regions in the base substrate at two sides of each of the gate structures; forming an interlayer dielectric layer over the base substrate and the source/drain doping regions; forming a mask layer having a plurality of first openings there-through and over the interlayer dielectric layer, the first opening having a first length; performing a surface treatment process to remove portions of the mask layer from the first openings and to increase the first length of the first opening; forming contact through holes passing through the interlayer dielectric layer and exposing the source/drain doping regions using the mask layer with the first openings having the increased first length as an etching mask; and forming a contact via in each of the contact through holes.

Preferably, the mask layer is one of a silicon-containing antireflective layer, a silicon oxynitride layer and a low temperature oxide layer.

Preferably, the surface treatment process is a directed ribbon-beam etching process.

Preferably, the first opening comprises a first sidewall perpendicular to a direction of the first length and a second sidewall parallel to the direction of the first length.

Preferably, an etching rate of the directed ribbon-beam etching process to the first sidewalls of the first opening is greater than an etching rate of the directed ribbon-beam etching process to the second sidewalls of the first openings.

Preferably, a ratio between the etching rate of the directed ribbon-beam etching process to the first sidewall of the first opening and the etching rate of the directed ribbon-beam etching process to the second sidewall of the first opening is in a range of approximately 10:1 to 200:1.

Preferably, the directed ribbon-beam etching process comprises: providing a pulsed DC bias to covert an etching gas into an inductively-coupled plasma; forming an ion beam using the inductively-coupled plasma; and scanning, by the ion beam, along a direction parallel to the direction of the first length of the first opening and bombarding the first sidewall perpendicular to the direction of the first length of the first opening.

Preferably, the mask layer being a silicon-containing antireflective layer, wherein: the pulsed DC bias for plasmarizing the etching gas is in a range of approximately 0-10 V; a pressure for plasmarizing the etching gas is in a range of approximately 0.1 Pa-10 Pa; the etching gas is CF4; a diluting gas of the etching gas includes one of He, Ar, and N2; a flow rate of the etching gas is in a range of approximately 10 sccm-2000 sccm; a flow rate of the diluting gas is in a range of approximately 10 sccm-2000 sccm; an energy of the ion beam bombarding the first sidewall is in a range of approximately 100 eV-500 eV; a pressure during bombarding the first sidewall is in a range of approximately 2 mTorr-5 Torr; and an angle between the ion beam and a normal of the base substrate is in a range of approximately 20°-80°.

Preferably, the first length of the first opening is increased by approximately 3.5 nm to 4.5 nm.

Preferably, forming the mask layer having the plurality of first openings comprises: forming a mask material layer over the interlayer dielectric layer; forming a photoresist layer having patterned openings exposing the mask material layer on the mask material layer; etching the mask material layer along the patterned openings using the photoresist layer as an etching mask to form the plurality of first openings passing through the mask material layer; and removing the photoresist layer.

Preferably, after forming the interlayer dielectric layer over the source/drain doping regions and before forming the mask layer having the plurality of first openings, further comprising: forming a cover layer over the interlayer dielectric layer.

Preferably, the cover layer is an organic dielectric layer.

Preferably, forming the contact through holes exposing the source/drain doping regions in the interlayer dielectric layer comprises: etching the cover layer along the first openings of the mask layer using the mask layer as etching mask to form second openings there-through; and etching the interlayer dielectric along the second openings using the mask layer as an etching mask until the source/drain doping regions are exposed.

Preferably, the gate structures are dummy gate structures and the interlayer dielectric layer includes a first interlayer dielectric layer and a second interlayer dielectric layer, and wherein forming the contact through holes comprises: forming the second interlayer dielectric layer over the base substrate between the dummy gate structures, a top of the second interlayer dielectric layer leveling with tops of the dummy gate structures; removing the dummy gate structures to form openings in the second interlayer dielectric layer; forming a metal gate structure in each of the openings; and forming the first interlayer dielectric layer over the second interlayer dielectric layer and the metal gate structures.

Preferably, forming contact through holes comprises: forming second openings passing through the cover layer by etching the cover layer along the first openings using the mask layer as an etching mask; and etching the first interlayer dielectric layer and the second interlayer dielectric along the second openings to form the contact through holes passing through the top interlayer dielectric layer and the bottom interlayer dielectric layer.

Preferably, the semiconductor structure is a fin field-effect transistor structure; the base substrate includes a semiconductor substrate and a plurality of fins protruding from the semiconductor substrate; the gate structures cross over the fins and cover portions of top and side surfaces of the fins; and the source/drain doping regions are formed in fins at two sides of each of the gate structures.

A second aspect of the present invention provides a semiconductor structure.

The semiconductor structure includes a base substrate; gate structures formed on the base substrate; source/drain doping regions formed in the base substrate at two sides of each of the gate structures; an interlayer dielectric layer formed over the base substrate and the source/drain doping regions; and contact vias electrically in contact with the source/drain doping regions formed in the interlayer dielectric layer. The contact vias are formed by forming a mask layer having a plurality of first openings there-through and over the interlayer dielectric layer, the first opening having a first length; performing a surface treatment process to remove portions of the mask layer from the first openings and to increase the first length of the first opening; forming contact through holes passing through the interlayer dielectric layer and exposing the source/drain doping regions using the mask layer with the first openings having the increased first length as an etching mask; and forming a contact via in each of the contact through holes.

Preferably, the semiconductor structure is a fin field-effect transistor structure.

Preferably, the base substrate includes a semiconductor substrate and a plurality of fins protruding from the semiconductor substrate.

Preferably, the gate structures cross over the fins and cover portions of top and side surfaces of the fins.

Preferably, the source/drain doping regions are formed in the fins at two sides of each of the gate structures.

Preferably, the surface treatment process is a directed ribbon-beam etching process.

Preferably, the contact vias are made of W.

Preferably, the mask layer is an antireflective layer.

A semiconductor structure according to the first aspect of the present invention may be obtained by a method according to the present invention.

Other aspects of the present invention can be understood by those skilled in the art in light of the description, the claims, and the drawings of the present invention.

### BRIEF DESCRIPTION OF THE DRAWINGS

Figure 1 is a scanning electron microscope (SEM) image of contact through holes;
Figure 2 illustrates a top view of a structure when forming contact through holes;
Figure 3 is an SEM image of the contact through holes formed in Figure 2;
Figures 4-14 illustrate semiconductor structures corresponding to certain stages of an exemplary fabrication process of a semiconductor structure consistent with the disclosed embodiments; and
Figure 15 illustrates an exemplary fabrication process of a semiconductor structure consistent with the disclosed embodiments.

### DETAILED DESCRIPTION

Reference will now be made in detail to exemplary embodiments of the disclosure, which are illustrated in the accompanying drawings. Wherever possible, the same reference numbers will be used throughout the drawings to refer to the same or like parts.

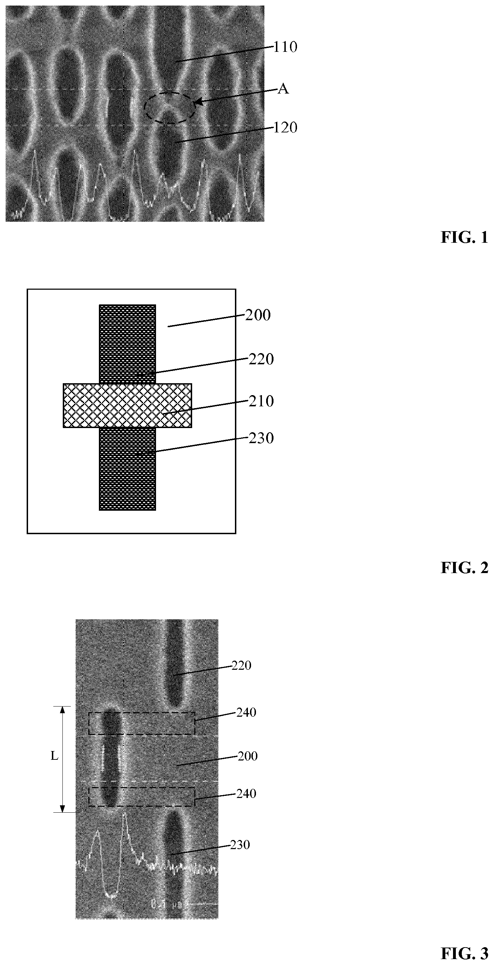

Contact through holes formed by the existing techniques may deteriorate the electrical properties of the semiconductor structures. Figure 1 is a scanning electron microscope (SEM) image of contact through holes.

As shown in Figure 1, a first contact through hole 110 and a second contact through 120 are illustrated. With the continuous shrinking of the technical node of the IC processes, the distance between the first contact through hole 110 and the second contact through hole 120 has become smaller and smaller. Thus, during the process for forming the first contact through hole 110 and the second contact through hole 120, the critical dimension of the photoresist layer along the direction parallel to the surface of the substrate has also become smaller and smaller, especially for the portion of the photoresist layer on the mask layer between the first contact through hole 110 and the second contact through hole 120. During the process for forming the mask layer, the portion of the photoresist layer between the first contact through hole 110 and the second contact through hole 120 may be completely or partially removed because of the relatively small size. Thus, the distance between the first contact through hole 110 and the adjacent second contact through hole 120 may be too small, or the first contact through hole 110 and the second contact through hole 120 may be connected (as shown as in the region "A" in Figure 1). Accordingly, the first contact via formed in the first contact through hole 110 and the second contact via formed in the second contact through hole 120 may be short-circuited. Therefore, the electrical properties and the yield of the semiconductor device may all be reduced.

Figure 2 illustrates a top view of a structure when forming contact through holes. For illustrative purposes, the position relationship between an interlayer dielectric layer, contact through holes and an etching barrier layer are shown herein.

As shown in Figure 2, to solve the short circuit issue between the first contact through hole and the second contact through hole, a patterned etching barrier layer 210 is formed on the interlayer dielectric layer 200. The projective view of the etching barrier layer 210 on the substrate of the semiconductor structure is between the projective views of the subsequently formed first contact through hole 220 and the subsequently formed second contact through hole 230 on the substrate. Further, a mask having the patterns of the contact through holes (not shown) is formed on the interlayer dielectric layer 200. The openings of the patterns of the contact through holes cross over the regions corresponding to the subsequently formed first contact through hole 220 and the second contact through 230, and expose regions of the interlayer dielectric layer 200 corresponding to the subsequently formed first contact through hole 220 and the second contact through hole 230. Then, the interlayer dielectric layer 200 is etched using the mask layer as an etching mask to form the first contact through hole 220 in the interlayer dielectric layer 200 at one side of the etching barrier layer 210 and the second contact through hole 230 in the interlayer dielectric layer 200 at the other side of the etching barrier layer 210. The first contact through hole 220 and the second contact through 230 pass through the interlayer dielectric layer 200.

During the process for etching the interlayer dielectric layer 200, the etching barrier layer 210 is used as an etching mask, it is unnecessary to form a photoresist layer on the mask layer between the first contact through hole 220 and the second contact through hole 230. Thus, the completely removing or partially removing issue of the photoresist layer during the developing process may be avoided. Accordingly, the too small distance issue or the connection issue between the first contact through hole 220 and the second contact through hole 230 may be avoided.

However, in the practical fabrication processes, the feature size of the structures after an etching process is smaller than the feature size after a photolithography process. That is, the feature size of the formed first contact through hole 220 and/or the feature size of the formed second contact through hole 230 is smaller than the size of the patterns of the first contact through hole 220 and/or the second contact through hole 230 in the photoresist layer or the photomask.

Figure 3 is an SEM image of the contact through holes formed by the above-described processes. For illustrative purposes, the contact through holes are formed in a fin field-effect transistor structure. The dashed frame region corresponds to a fin 240 under the first contact through hole 220 and the second contact through hole 230. If the length "L" of the first contact through hole 220 or the second contact through hole 230 along its length direction (i.e., a direction perpendicular to the fin 240) is too large, it is difficult for the first contact through hole 220 and the second contact through hole 230 to expose the source/drain doping regions in the fin 240. Thus, the subsequently formed contact vias are unable to be in contact with the source/drain doping regions. Accordingly, the electrical properties of the semiconductor device may be affected; and the yield may be reduced.

The present invention provides a semiconductor structure and a fabrication method thereof. The fabrication method may include providing a base substrate; forming gate structures over the base substrate; forming source/drain doping regions in the base substrate at two sides of each of the gate structures; forming an interlayer dielectric layer over the source/drain doping regions; and forming a mask layer having a plurality of first openings over the interlayer dielectric layer. The first openings may pass through the mask layer; and the cross-sectional view of the first openings along a direction parallel to the surface of the base substrate may have a rectangle shape may have a first length along the direction of the long side of the first openings. The direction parallel to the long sides of the first openings may be referred to as a length direction of the first openings. Further, the fabrication method may include performing a surface treatment to remove portions of the mask layer from the first openings to increase the first length of the first openings; and etching the interlayer dielectric layer using the mask layer having the first openings with the increased first length as an etching mask to form contact through holes passing through the interlayer dielectric layer and exposing the source/drain doping regions. Further, the fabrication method may also include forming contact vias in the contact through holes.

In the present invention, the mask layer having a plurality of first openings are formed firstly, followed by performing a surface treatment process to remove portions of the mask layer to increase the first length. Correspondingly, after forming the contact through holes using the mask layer obtained by the surface treatment process, the length along the length direction of the contact through holes may also be increased. Thus, the difficulty for exposing the source/drain doping regions caused by too small lengths of the contact through holes may be avoided; and the electrical properties of the semiconductor structure may be improved.

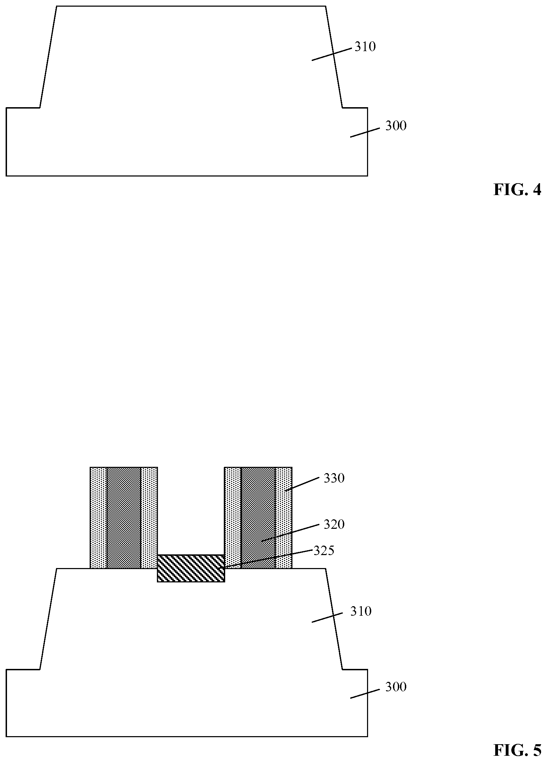

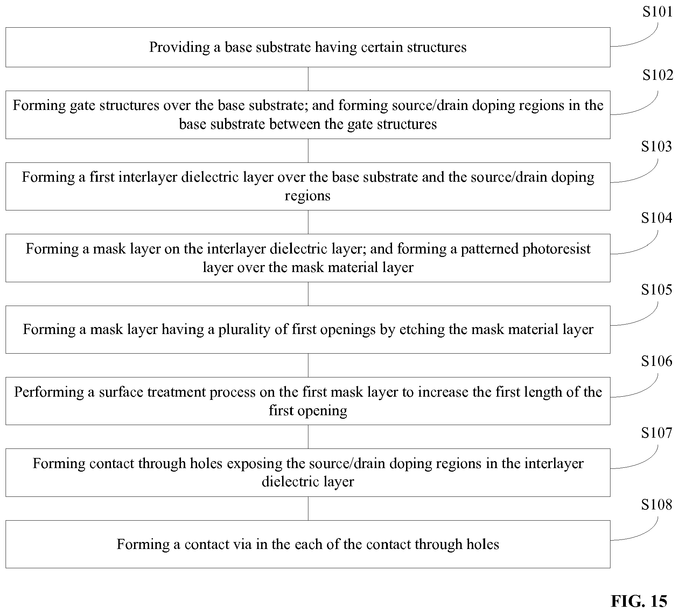

Figure 15 illustrates an exemplary fabrication process of a semiconductor structure consistent with the disclosed embodiments. Figures 4-14 illustrate semiconductor structures corresponding to certain stages of the exemplary fabrication process.

As shown in Figure 15, at the beginning of fabrication process, a base substrate with certain structures is provided (S101). Figure 4 illustrates a corresponding semiconductor structure.

As shown in Figure 4, a base substrate is provided. The base substrate provides a process platform for forming the semiconductor structure.

In one embodiment, the semiconductor structure is a FinFET structure. Thus, the base substrate may include a semiconductor substrate 300 and a plurality of fins 310 protruding from the surface of the semiconductor substrate 300 and on the surface of the semiconductor substrate 300. For illustrative purposes, one fin 310 is shown in Figure 4, although any number of fins may be formed and included in the disclosed semiconductor structure.

In one embodiment, the semiconductor substrate 300 is made of Si. In some embodiments, the semiconductor substrate 300 may be made of Ge, SiGe, SiC, GaAs, or GaIn, etc. The semiconductor substrate 300 may also be a silicon on insulator (SOI) substrate, or a germanium on insulator (GOI) substrate, etc.

The fins 310 and the semiconductor substrate 300 may be made of a same material, or different materials. In one embodiment, the fins 310 and the semiconductor substrate 300 are made of a same material. Specifically, the semiconductor substrate 300 is made of Si; and the fins 310 are made of Si. In some embodiments, the fins may be made of Ge, SiGe, SiC, GaAs, or GaIn, etc.

In another embodiment, the semiconductor structure may be a planar transistor structure. The base substrate may be a planar semiconductor substrate. The planar semiconductor substrate may be made of Si, Ge, SiGe, SOI, GOI, glass, and/or group III-compound semiconductor (such as GaN or GaAs, etc.). Gate structures may be subsequently formed on the planar semiconductor substrate.

Specifically, the process for forming the semiconductor substrate 300 and the plurality of fins 310 may include providing an initial base substrate; forming a patterned hard mask layer (not shown) on the initial base substrate; and etching the initial base substrate using the patterned hard mask layer as an etching mask. The initial base substrate after the etching process may be configured as the semiconductor substrate 300. The protruding portions of the initial base substrate on the surface of the semiconductor substrate 300 may be configured as the plurality of fins 310. After the etching process, the patterned hard mask layer may be removed.

Returning to Figure 15, after forming the plurality of fins 310, a plurality of gate structures may be formed (S102). Figure 5 illustrates a corresponding semiconductor structure.

As shown in Figure 5, a plurality of gate structures 320 are formed over the base substrate. The gate structures 320 may cross over the fins 310; and the gate structures 320 may cover portions of the side and top surfaces of the fins 310.

Specifically, the process for forming the gate structures 320 may include forming a gate electrode film covering the fins 310 over the base substrate; planarizing the gate electrode film; and patterning the planarized gate electrode film. Thus, the gate structures 320 may be formed.

The gate structures 320 may be any appropriate structures. In one embodiment, the gate structures 320 are dummy gate structures. In some embodiments, the gate structures may be metal gate structures.

The gate structures 320 may be single-layer structures, or multiple-layer stacked structures. The gate structures 320 may include a dummy gate layer. The gate structures 320 may also include a dummy oxide layer; and the dummy gate layer may be formed on the dummy oxide layer.

The dummy gate layer may be made of any appropriate material, such as polysilicon, silicon nitride, silicon oxynitride, silicon caribide, silicon carbonitride, silicon carbonoxynitride, or amorphous carbon, etc. The dummy oxide layer may be made of silicon oxide, or silicon oxynitride, etc.

Further, referring to Figure 5, after forming the gate structures 320, sidewall spacers 330 may be formed on the side surfaces of the gate structures 320. The sidewall spacers 330 may be made of a material different from that of the subsequently formed dielectric layer. Thus, the sidewall spacers 330 may be able to protect the gate structures 320; and may also be used as an etching mask for subsequently forming the contact through holes.

In one embodiment, the sidewall spacers 330 are made of silicon oxide. In some embodiments, the sidewall spacers may be made of silicon oxide, silicon oxynitride, silicon carbide, silicon oxycarbide, or silicon carbonoxynitride, etc.

Further, after forming the sidewalls spacers 330, source/drain doping regions 325 may be formed in the base substrate at two sides of each of the gate structures 320. In one embodiment, as shown in Figure 5, the source/drain doping regions 325 may be formed in the fins 310 at both sides of each of the gate structures 320. For illustrative purposes, one source/drain region 325 between two adjacent gate structures 320 is shown. In one embodiment, the source/drain doping regions 325 in the fins 310 between adjacent gate structures 320 may be shared by the transistors having the adjacent gate structures 320. For example, a common source or common drain for the adjacent gate structures 320 may be formed.

The process for forming the source/drain doping regions 325 may include forming stress layers (not shown) in the fins 310, followed by doping the stress layers to form the source/drain doping regions 325. In one embodiment, the stress layers may be in situ doped during the process for forming the stress layers. In some embodiments, the stress layers may be doped by an ion implantation process after forming the stress layers.

When the base substrate is used to form N-type transistors, the source/drain doping regions 325 may be doped with N-type ions, such as P ions, As ions, or Sb ions, etc. When the base substrate is used to form P-type transistors, the source/drain doping regions 325 may be doped with P-type ions, such as B ions, Ga ions, or In ions, etc.

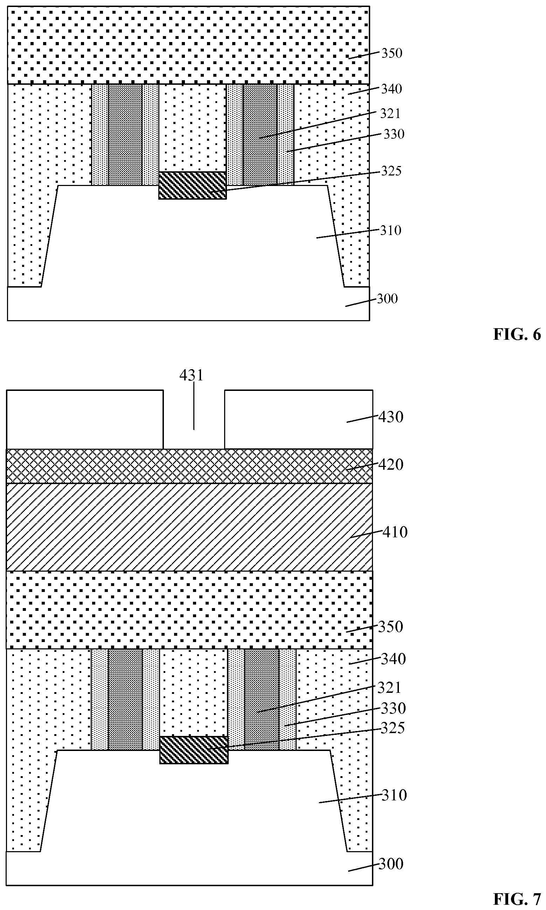

Returning to Figure 15, after forming the source/drain doping regions 325, a first interlayer dielectric layer may be formed (S103). Figure 6 illustrates a corresponding semiconductor structure.

As shown in Figure 6, a first interlayer dielectric layer 350 is formed over the semiconductor substrate 300, the source/drain doping regions 325 and the gate structures 320. Before forming the first interlayer dielectric layer 350, a second interlayer dielectric layer 340 may be formed over the base substrate among the gate structures 320. The first interlayer dielectric layer 350 and the second interlayer dielectric layer 340 together may be referred to as an interlayer dielectric layer.

The first interlayer dielectric layer 350 may provide a process platform for subsequently forming the contact through holes. The first interlayer dielectric layer 350 may also provide a process platform for subsequently forming a back-end-of-line (BEOL) metal layer.

The first interlayer dielectric layer 350 may be made of an insulation material, such as silicon oxide, silicon nitride, silicon oxynitride, silicon oxycarbide, or silicon carbon oxyntride, etc. In one embodiment, the first interlayer dielectric layer 350 is made of silicon oxide.

After forming the source/drain doping regions 325 and before forming the first interlayer dielectric layer 350, the second interlayer dielectric layer 340 may be formed over the base substrate among the gate structures 320 (as shown in Figure 5). The top surface of the second interlayer dielectric layer 340 may level with the top surfaces of the gate structures 320. Then, the gate structures 320 may be removed to form openings in the second interlayer dielectric layer 340; and metal gate structures 321 may be formed in the openings. The top surfaces of the metal gate structures 321 may level with the top surface of the second interlayer dielectric layer 340. The first interlayer dielectric layer 350 may be formed on the top surfaces of the second interlayer dielectric layer 340 and the metal gate structures 321.

The second interlayer dielectric layer 340 may be made of an insulation material, such as silicon oxide, silicon nitride, silicon oxynitride, silicon oxycarbide, or silicon carbon oxyntride, etc. In one embodiment, the second interlayer dielectric layer 340 is made of silicon oxide.

Various processes may be used to form the second interlayer dielectric layer 340 and the top interlayer dielectric layer 350, such as a chemical vapor deposition (CVD) process, a plasma-enhanced CVD (PECVD) process, or a low-pressure CVD (LPCVD) process, etc.

The metal gate structures 321 may include a gate dielectric layer (not labeled), and a gate electrode layer (not labeled) formed on the gate dielectric layer. The gate dielectric layer may cross over the fins 310; and may cover portions of the top and side surfaces of the fins 310.

The gate dielectric layer may be made of a high-K dielectric material, etc. The high-K dielectric material may refer to the material having a relative dielectric constant greater than the dielectric constant of silicon oxide. The high-K dielectric material may include HfO₂, HfSiO, HfSiO, HfSiON, HfTaO, HfTiO, HfZrO, ZrO₂ or Al₂O₃, etc. In one embodiment, the gate dielectric layer is made of HfO₂.

The gate electrode layer may be made of any appropriate material. In one embodiment, the gate electrode layer is made of W. In some embodiments, the gate electrode layer may be made of Al, Cu, Ag, Au, Pt, Ni, or Ti, etc.

In one embodiment, the metal gate structures 321 are formed by a high-K last and metal gate last process. In some embodiments, the metal gate structures may be formed by a high-K first and metal gate first process.

In some embodiments, the gate structures may be conventional metal gate structures. During the process for forming the interlayer dielectric layer, the interlayer dielectric layer may be formed on the base substrate between the gate structures; and the top of the interlayer dielectric layer may be above the top surfaces of the gate structures.

Returning to Figure 15, after forming the first interlayer dielectric layer 350, a cover layer, a mask material layer and a patterned photoresist layer may be formed (S104). Figure 7 illustrates a corresponding semiconductor structure.

As shown in Figure 7, a cover layer 410 is formed on the first interlayer dielectric layer 350; a mask material layer 420 may be formed on the cover layer 410. Further, a patterned photoresist layer 430 having a plurality of patterned openings 431 exposing the mask material layer 420 may be formed on the mask material layer 420.

The cover layer 410 may have a planar surface; and may provide a process platform for forming the mask material layer. By using the cover layer 410 with the planar surface, a better pattern transfer may be achieved.

In one embodiment, the cover layer 410 may be an organic dielectric layer (ODL). The covering layer 410 may be formed by a spin-coating process, etc.

The mask material layer 420 may be used to subsequently form a mask layer having a plurality of first openings. The patterned photoresist layer 430 having the plurality of patterned openings 431 may be used as an etching mask for subsequently forming the mask layer.

The mask material layer 420 may be a silicon-containing antireflective layer. In some embodiments, the mask material layer 420 may be made of silicon oxynitride, or low-temperature silicon oxide, etc.

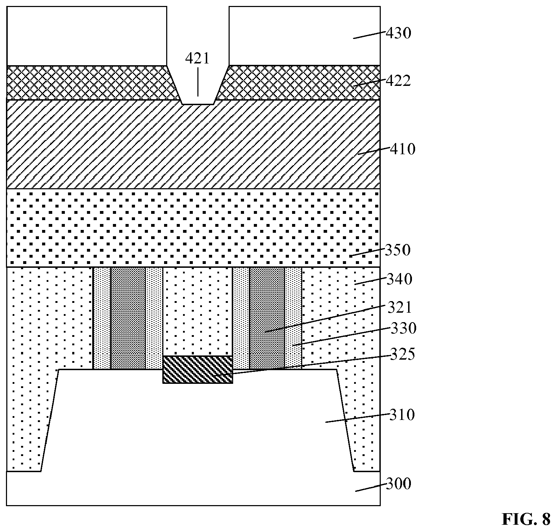

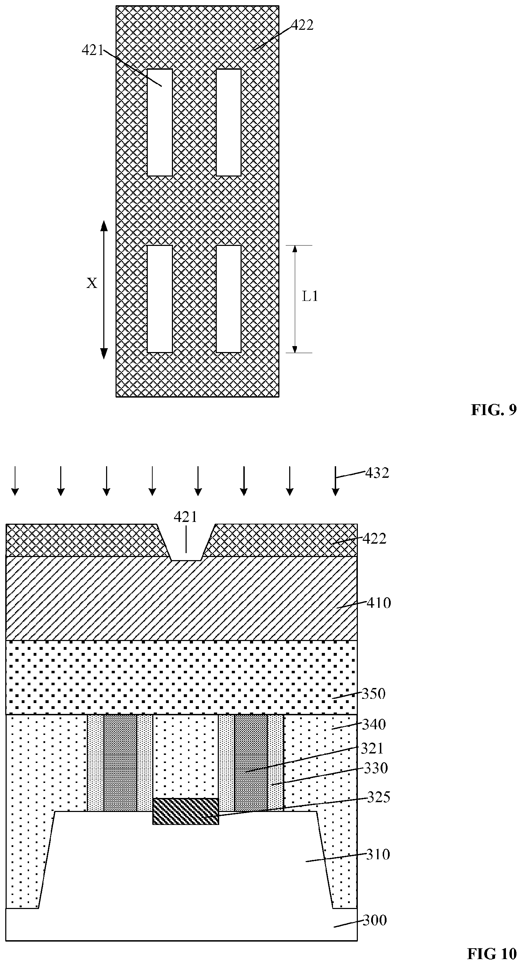

Returning to Figure 15, after forming the patterned photoresist layer 430, a mask layer may be formed (S105). Figures 8-9 illustrate a corresponding semiconductor structure. Figure 9 is a top view of a portion of the structure illustrated in Figure 8.

As shown in Figures 8-9, a mask layer 422 having a plurality of first openings 421 may be formed over the top interlayer dielectric layer 350. In one embodiment, the mask layer 422 is formed on the cover layer 410; and the plurality of first openings 421 may expose the surface of the cover layer 410. For illustrative purposes, four first openings 421 are shown in Figure 9.

The first openings 421 may pass through the mask layer 422; and the cross-sectional view of a first opening 421 along a direction parallel to the surface of the base substrate may be, for example, a rectangle. The first opening 421, e.g., having a rectangle shape, may have a first length "L" (as shown in Figure 9) along the long side direction of the rectangle. In some embodiments, the long side may be arranged in a direction parallel with a length direction of the fin 310. The direction parallel to the long side direction of the rectangle may be referred to as the length direction of the first opening 421 (referring to the X direction illustrated in Figure 9).

The mask layer 422 may be formed by etching the mask material layer 420 using the patterned photoresist layer 430 as an etching mask along the patterned openings 431 until the mask material layer 420 is etched through. Thus, the plurality of first openings 421 passing through the mask material layer 420 may be formed; and the remaining mask material layer 420 may be configured as the mask layer 422 having the plurality of first openings 421. After forming the mask layer 422, the patterned photoresist layer 430 may be removed.

The mask material layer 420 may be etched by any appropriate process. In one embodiment, a plasma dry etching process is used to etch the mask material layer 420. Specifically, the etching gas of the plasma dry etching process may be CF₄. In some embodiments, the etching gas of the plasma dry etching process may include one or more of fluorine-containing gas, such as CHF₃, or C₂F₆, etc.

The flow rate of the etching gas may be any appropriate value. If the flow rate of the etching gas is too small, the etching rate may be too small. Correspondingly, the process time may be increased; and the production efficiency may be reduced. If the flow rate of the etching gas is too large, the etching stability may be deteriorated, and the first length "L1" may be increased. Thus, the first length "L1" after the subsequent surface treatment process may be too large. Accordingly, the quality of the subsequently formed contact vias may be adversely affected. Thus, in one embodiment, the flow rate of the etching gas may be in a range of approximately 20 sccm-500 sccm.

The pressure of the etching chamber may be determined according to the flow rate of the etching gas. In one embodiment, the pressure of the etching chamber may be in a range of approximately 10 mTorr-200 mTorr.

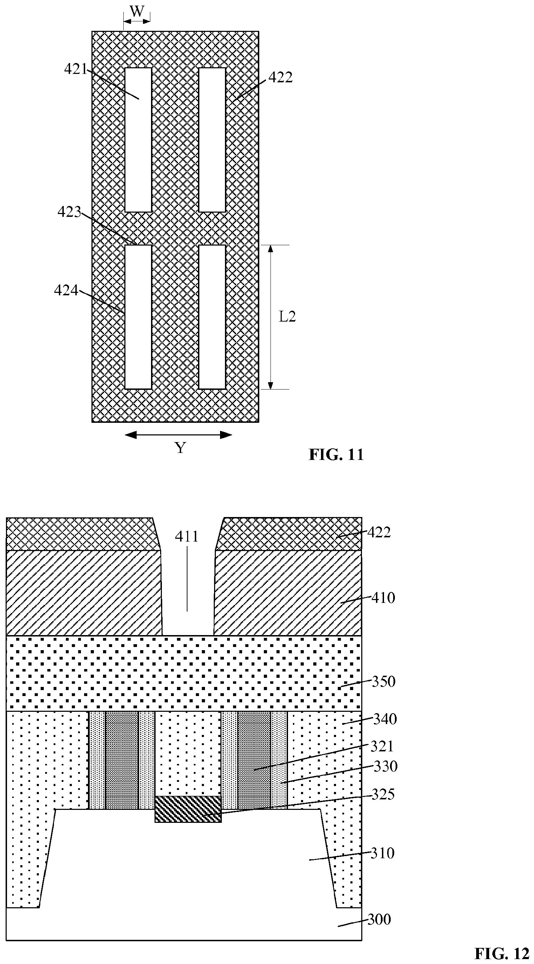

Returning to Figure 15, after forming the mask layer 422, a surface treatment process may be performed; and the first length "L1" of the first openings 421 may be increased (S106). Figures 10-11 illustrate a corresponding semiconductor structure. Figure 11 is a top view of a portion of the structure illustrated in Figure 10. For illustrative purposes, four first openings 421 are shown herein, although other number of first openings 421 may be included.

As shown in Figures 10-11, a surface treatment process 432 is performed to the mask layer 422 to remove portions of the mask layer 422 from the first openings. After the surface treatment process 432, the first length "L1" of the first opening 421 may be increased to be a second length "L2". That is, the long sides of the first openings 421 may have the second length "L2" along the length direction of the first opening 421 (the X direction illustrated in Figure 9).

The surface treatment process 432 may be any appropriate process. In one embodiment, the surface treatment process 432 is a directed ribbon-beam etching process (i.e., a ribbon-beam technology).

Referring to Figure 11, the first opening 421 may include a first sidewall 423 and a second sidewall 424. The first sidewalls 423 may be perpendicular to the length direction of the first opening 421; and the second sidewalls 424 may be parallel to the length direction of the first opening 421. The directed ribbon-beam etching process may have an etching rate to the first sidewalls 423 greater than an etching rate to the second sidewalls 424.

In one embodiment, the ratio between the etching rate of the directed ribbon-beam etching process to the first sidewalls 423 and the etching rate of the directed ribbon-beam etching process to the second sidewalls 424 may be in a range of approximately 10:1 to 200:1. By performing the surface treatment process 432, the length of first opening 421 (the first length) along the length direction of the first opening 421 may be increased. The surface treatment process 432 may have a substantially small effect to the width "W"' of the first opening 421 along the direction perpendicular to the length direction of the first opening 421, i.e., the Y direction illustrated in Figure 11. Thus, the adverse effect to the subsequently formed contact through holes may be avoided; and the performance reduction of the semiconductor structure may be avoided.

Specifically, the directed ribbon-beam etching process may include proving a pulsed DC bias to covert an etching gas to inductively coupled plasma (ICP) (i.e., a plamarizing process); and forming a plasma beam using the inductively coupled plasms. The plasma beam may scan along the length direction of the first openings 421 (the X direction illustrated in Figure 9); and may bombard the first sidewalls 423 of the first openings 421.

In one embodiment, the mask layer 422 may be a silicon-containing antireflective coating (Si-ARC), the etching gas of the directed ribbon-beam etching process may be CF₄; and the diluting gas may be H₂, Ar, or N₂, etc. In some embodiments, the etching gas may be one or more of the fluoride-based gas, including CF₄, CHF₃, and C₂F₆, etc.

The pulsed DC bias and the flow rate of the etching gas of the directed ribbon-beam etching process may be any appropriate value. If the pulsed DC bias and the flow rate of the etching gas are too small, the generated inductively-coupled plasma may be too small. The size increasing of the first openings 421 along the length direction of the first openings 421 may be unobvious. If the pulsed DC bias and the flow rate of the etching gas are too large, the etching rate may be too large, and the etching stability may be unacceptable. Accordingly, the size and the morphology of the first openings 421 after the etching process may be adversely affected. Thus, in one embodiment, the pulsed DC bias may be in a range of approximately 0 V-10 kV. The flow rate of the etching gas may be in a range of approximately 10 sccm- 2000 sccm.

The flow rate of the diluting gas may be any appropriate value. If the flow rate of the diluting gas is too low, the etching rate may be too fast and the etching stability may be unacceptable; and the size and morphology of the first openings 421 after the etching process may be adversely affected. If the flow rate of the diluting gas is too high, the etching rate may be too slow. Correspondingly, the process time may be increased; and the production efficiency may be reduced. Thus, in one embodiment, the flow rate of the diluting gas may be in a range of approximately 10 sccm-2000 sccm.

The pressure of the etching chamber may be determined to be in an appropriate value range according to the flow rate of the etching gas, the flow rate of the diluting gas and the pulsed DC bias. In one embodiment, the pressure of the etching chamber may be in a range of approximately 0.1 Pa-10 Pa.

The energy of the ion beam of the ribbon-beam etching process may be any appropriate value. If the energy of the ion beam is too small, the size increasing of the first openings 421 along the length direction may be unobvious. If the energy of the ion beam is too large, the etching rate may be too fast; and the etching stability may be unacceptable. Accordingly, the size and the morphology of the first openings 421 after the etching process may be adversely affected. In one embodiment, the energy of the ion beam may be in a range of approximately 100 eV to 500 eV.

The angle between the ion beam of the directed ribbon-beam etching process and the normal of the surface of the base substrate may be any appropriate value. If the angle between the ion beam and the normal of the surface of the base substrate is too small, the etching rate of the first sidewalls 423 may be too slow. Accordingly, the process time may be increased; and the production cost may be increased. If the angle between the ion beam and the normal of the surface of the base substrate is too large, the shadow effect may be severe. After the directed ribbon-beam etching process, the morphology of the sidewalls 423 may be changed. Accordingly, when the mask layer 422 is subsequently used as an etching mask to form contact through-holes, the morphology of the first openings 421 may be transferred to the contact through holes. Thus, the quality of the contact through holes may be adversely affected. Thus, in one embodiment, the angle between the ion beam and the normal of the surface of the base substrate may be in a range of approximately 20°-80°.

The pressure of the etching chamber may be determined to be in an appropriate value range according to the energy of the ion beam and the angle between the ion beam and the normal of the surface of the base substrate. In one embodiment, the pressure of the etching chamber may be in a range of approximately 2 mTorr-5 Torr.

In one embodiment, after the surface treatment process 432, the length of the first openings 421 along the length direction is increased. Specifically, the first length "L1" of the first opening 421 along the length direction (as shown in Figure 9) may be increased approximately 3.5 nm-4.5 nm. That is, after the surface treatment process 432, the difference between the second length "L2" (as shown in Figure 11) and the first length "L1" may be in a range of approximately 3.5 nm-4.5 nm.

In one embodiment, the ratio of the etching rate of the directed ribbon-beam etching process to the mask layer 422 and the etch rate of the directed ribbon-beam etching process to the cover layer 410 may be approximately 20:1. The etching rate of the directed ribbon-beam etching process to the mask layer 422 is greater than the etch rate of the directed ribbon-beam etching process to the cover layer 410. Thus, after the ribbon-beam etching process, the removed amount of the cover layer 410 may be relatively small.

Returning to Figure 15, after performing the surface treatment process 432, contact through holes may be formed (S107). Figures 12-13 illustrate corresponding semiconductor structures.

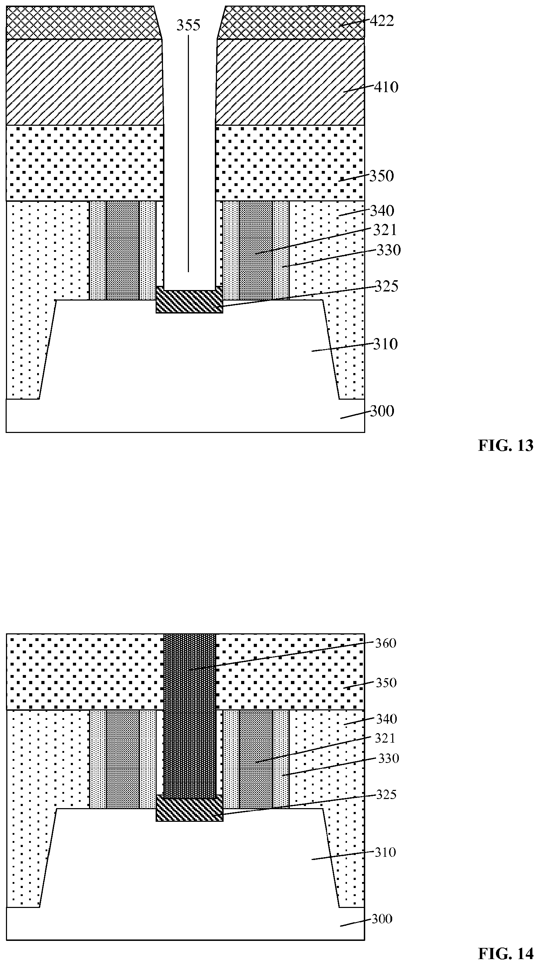

As shown in Figure 12, after performing the surface treatment process 432, second openings 411 passing through the cover layer 410 may be formed in the covering layer 410 by etching the cover layer 411 along the first openings 421 using the mask layer 422 as an etching mask. Then, the top interlayer dielectric layer 350 and the bottom interlayer dielectric layer 340 may be sequentially etched along the second openings 411 using the mask layer 422 as an etching mask until the source/drain doping regions 325 are exposed. Thus, as shown in Figure 13, the contact through holes 355 may be formed in the top interlayer dielectric layer 350 and the bottom interlayer dielectric layer 340.

The contact through holes 355 may provide spaces for subsequently forming contact vias. Further, because the contact through holes 355 may expose the source/drain doping regions 325, the subsequently formed contact vias may electrically contact with the source/drain doping regions 325.

Referring to Figure 13, the second interlayer dielectric layer 340 may be formed over the base substrate between the metal gate structures 321; the top surface of the second interlayer dielectric layer 340 may level with the tops of the metal gate structures 321; the first interlayer dielectric layer 350 may be formed on the metal gate structures 321 and the second interlayer dielectric layer 340; and the second interlayer dielectric layer 340 and the first interlayer dielectric layer 350 may be made of a same material (may be configured as an interlayer dielectric layer). Thus, during the process for forming the contact through holes 355, the second interlayer dielectric layer 340 and the first interlayer dielectric layer 350 may be etched by a same etching process.

The second interlayer dielectric layer 340 and the first interlayer dielectric layer 350 may be etched by any appropriate process. In one embodiment, the second interlayer dielectric layer 340 and the first interlayer dielectric layer 350 are etched by a plasma dry etching process. Specifically, the etching gas may include CF₄; and the diluting gas may be He. The pressure of the etching chamber may be in a range of approximately 20 mTorr-200 mTorr. The flow rate of CF₄ may be in a range of approximately 50 sccm-1000 sccm. The flow rate of He may be in a range of approximately 50 sccm-1000 sccm. In some embodiments, the etching gas may include one or more of fluorine-containing gas, such as CHF₃, and C₂F₆, etc.

After forming the contact through holes 355, the mask layer 422 and the cover layer 410 may be removed. Various processes may be used to remove the mask layer 422 and the cover layer 410. In one embodiment, a dry etching process is used to remove the mask layer 422 and the cover layer 410.

Returning to Figure 15, after forming the contact through holes 355, contact vias may be formed (S108). Figure 14 illustrates a corresponding semiconductor structure.

As shown in Figure 14, a contact via 360 is formed in each contact through hole 355. The contact vias 360 may contact with the source/drain doping regions 325; and may be used to achieve electrical interconnect between semiconductor devices; and/or to achieve electrical interconnect between semiconductor devices and external devices and/or circuits.

The process for forming the contact vias 360 may include forming a conductive material layer in the contact through holes 355 (referring to Figure 13) and on the top surface of the top interlayer dielectric layer 350, followed by removing the conductive material layer above the top interlayer dielectric layer 350. The contact vias 360 may be formed in the contact through holes 355.

The contact vias 360 may be made of any appropriate material, such as W, Al, Cu, Ag, or Au, etc. In one embodiment, the contact vias 360 is made of W. Various processes may be used to form the conductive material layer, such a CVD process, a sputtering process, or an electroplating process, etc. The conductive material layer above the top surface of the first interlayer dielectric layer 350 may be removed by any appropriate process, such as an etching process, or a chemical mechanical polishing process, etc.

In the disclosed embodiments, a mask layer having a plurality of first openings 421 (referring to Figure 8) may be formed firstly, followed by a surface treatment process 432(referring to Figure 10). The surface treatment process 432 may increase the first length of the first openings 421 along the length direction (the "X" direction illustrated in Figure 9). Correspondingly, after forming the contact through holes 350 using the mask layer 422 treated by the surface treatment process 432, the first length of the contact through holes 350 along the length direction may also be increased (referring to Figure 13). Thus, the difficulty for the contact through holes 350 to expose the source/drain doping regions 325 caused by the too small size of the contact through holes 350 along the length direction may be avoided. Accordingly, the difficulty for the subsequently forming contact vias 360 to electrically connect with the source/drain doping regions 325 may be avoided; and the electrical properties of the semiconductor devices may be enhanced.

Thus, a semiconductor structure may be formed by the disclosed methods and processes. Figure 14 illustrates a corresponding semiconductor structure.

As shown in Figure 14, the semiconductor structure includes a semiconductor substrate 300; and a plurality of fins 310 formed on the semiconductor substrate 300. The semiconductor structure may also include a bottom interlayer dielectric layer 340 formed over the semiconductor substrate 300 and the fins 310; and metal gate structures 321 formed on the fins 310 and in the bottom interlayer dielectric layer 340. Further, the semiconductor structure may also include sidewall spacers 330 on side surfaces of the metal gate structures 321; and source/drain doping regions 325 formed in the fins 310 between the metal gate structures 321. Further, the semiconductor structure may also include a top interlayer dielectric layer 350 and contact vias 360 electrically connecting with the source/drain doping regions 325 and passing through the top interlayer dielectric layer 350 and the bottom interlayer dielectric layer 340. The detailed structures and intermediate structures are described above with respect to the fabrication processes.

Thus, according to the disclosed embodiments, a mask layer having a plurality of first openings may be formed firstly, followed by a surface treatment process. The surface treatment process may increase the first length of the first openings along the length direction. Correspondingly, after forming the contact through holes using the mask layer treated by the surface treatment process, the first length of the contact through holes along the length direction may also be increased. Thus, the difficulty for the contact through holes to expose the source/drain doping regions caused by the too small size of the contact through holes along the length direction may be avoided. Accordingly, the difficulty for the subsequently formed contact vias to electrically connect with the source/drain doping regions may be avoided; and the electrical properties of the semiconductor devices may be enhanced.

Further, a directed ribbon-beam etching process may be used as the surface treatment process. The ratio between the etching rate of the ribbon-beam etching process to the first sidewalls and the etching rate of the ribbon-beam etching process to the second sidewalls may be in a range of approximately 10:1 to 200:1. Thus, during the process for increasing the size of the first openings along a direction parallel to the length direction, the size of the first openings along a direction perpendicular to the length direction may not be significantly affected. Thus, the adverse effect to the contact vias may be avoided. Accordingly, the electrical properties of the semiconductor structure may not be adversely affected.

## Claims

1. A method for fabricating a semiconductor structure, comprising:
providing a base substrate;
forming gate structures over the base substrate;
forming source/drain doping regions in the base substrate at two sides of each of the gate structures;
forming an interlayer dielectric layer over the base substrate and the source/drain doping regions;
forming a mask layer having a plurality of first openings there-through and over the interlayer dielectric layer, the first opening having a first length;
performing a surface treatment process to remove portions of the mask layer from the first openings and to increase the first length of the first opening;
forming contact through holes passing through the interlayer dielectric layer and exposing the source/drain doping regions using the mask layer with the first openings having the increased first length as an etching mask; and
forming a contact via in each contact through hole.

2. The method according to claim 1, wherein
the mask layer is one of a silicon-containing antireflective layer, a silicon oxynitride layer and a low temperature oxide layer; and/or
the first length of the first opening is increased by approximately 3.5 nm to 4.5 nm.

3. The method according to claim 1, wherein:
the surface treatment process is a directed ribbon-beam etching process.

4. The method according to claim 3, wherein:
the first opening comprises a first sidewall perpendicular to a direction of the first length and a second sidewall parallel to the direction of the first length;
an etching rate of the directed ribbon-beam etching process to the first sidewalls of the first opening is greater than an etching rate of the directed ribbon-beam etching process to the second sidewalls of the first openings.

5. The method according to claim 4, wherein:
a ratio between the etching rate of the directed ribbon-beam etching process to the first sidewall of the first opening and the etching rate of the directed ribbon-beam etching process to the second sidewall of the first opening is in a range of approximately 10:1 to 200:1.

6. The method according to claim 5, wherein the directed ribbon-beam etching process comprises: providing a pulsed DC bias to covert an etching gas into an inductively-coupled plasma; forming an ion beam using the inductively-coupled plasma; and scanning, by the ion beam, along a direction parallel to the direction of the first length of the first opening and bombarding the first sidewall perpendicular to the direction of the first length of the first opening; and
wherein preferably: the mask layer being a silicon-containing antireflective layer, wherein: the pulsed DC bias for plasmarizing the etching gas is in a range of approximately 0-10 V; a pressure for plasmarizing the etching gas is in a range of approximately 0.1 Pa-10 Pa; the etching gas is CF4; a diluting gas of the etching gas includes one of He, Ar, and N2; a flow rate of the etching gas is in a range of approximately 10 sccm-2000 sccm; a flow rate of the diluting gas is in a range of approximately 10 sccm-2000 sccm; an energy of the ion beam bombarding the first sidewall is in a range of approximately 100 eV-500 eV; a pressure during bombarding the first sidewall is in a range of approximately 2 mTorr-5 Torr; and an angle between the ion beam and a normal of the base substrate is in a range of approximately 20°-80°.

7. The method according to anyone of the claims 1-6, wherein forming the mask layer having the plurality of first openings comprises:
forming a mask material layer over the interlayer dielectric layer;
forming a photoresist layer having patterned openings exposing the mask material layer on the mask material layer;
etching the mask material layer along the patterned openings using the photoresist layer as an etching mask to form the plurality of first openings passing through the mask material layer; and
removing the photoresist layer.

8. The method according to anyone of the claims 1-7, after forming the interlayer dielectric layer over the source/drain doping regions and before forming the mask layer having the plurality of first openings, further comprising:forming a cover layer over the interlayer dielectric layer.

9. The method according to claim 8, wherein:
the cover layer is an organic dielectric layer; and/or
forming the contact through holes exposing the source/drain doping regions in the interlayer dielectric layer comprises: etching the cover layer along the first openings of the mask layer using the mask layer as etching mask to form second openings there-through; and etching the interlayer dielectric along the second openings using the mask layer as an etching mask until the source/drain doping regions are exposed.

10. The method according to anyone of the claims 1-9,
wherein the gate structures are dummy gate structures and the interlayer dielectric layer includes a first interlayer dielectric layer and a second interlayer dielectric layer, and
wherein forming the contact through holes comprises:
forming the second interlayer dielectric layer over the base substrate between the dummy gate structures, a top of the second interlayer dielectric layer leveling with tops of the dummy gate structures;
removing the dummy gate structures to form openings in the second interlayer dielectric layer; forming a metal gate structure in each of the openings; and
forming the first interlayer dielectric layer over the second interlayer dielectric layer and the metal gate structures.

11. The method according to claim 10,
wherein forming contact through holes comprises:
forming second openings passing through the cover layer by etching the cover layer along the first openings using the mask layer as an etching mask; and
etching the first interlayer dielectric layer and the second interlayer dielectric along the second openings to form the contact through holes passing through the top interlayer dielectric layer and the bottom interlayer dielectric layer.

12. The method according to anyone of the claims 1-11, wherein:
the semiconductor structure is a fin field-effect transistor structure;
the base substrate includes a semiconductor substrate and a plurality of fins protruding from the semiconductor substrate;
the gate structures cross over the fins and cover portions of top and side surfaces of the fins; and
the source/drain doping regions are formed in fins at two sides of each of the gate structures.

13. A semiconductor structure, comprising:
a base substrate;
gate structures formed on the base substrate;
source/drain doping regions formed in the base substrate at two sides of each of the gate structures;
an interlayer dielectric layer formed over the base substrate and the source/drain doping regions; and
contact vias electrically in contact with the source/drain doping regions formed in the interlayer dielectric layer,
wherein the contact vias are formed by:
forming a mask layer having a plurality of first openings there-through and over the interlayer dielectric layer, the first opening having a first length;
performing a surface treatment process to remove portions of the mask layer from the first opening and to increase the first length of the first opening;
forming contact through holes passing through the interlayer dielectric layer and exposing the source/drain doping regions using the mask layer with the first openings having the increased first length as an etching mask; and
forming a contact via in each of the contact through hole.

14. The semiconductor structure according to claim 13, wherein:
the semiconductor structure is a fin field-effect transistor structure;
the base substrate includes a semiconductor substrate and a plurality of fins protruding from the semiconductor substrate;
the gate structures cross over the fins and cover portions of top and side surfaces of the fins; and
the source/drain doping regions are formed in the fins at two sides of each of the gate structures.

15. The semiconductor structure according to claim 16, wherein at least one of:
the surface treatment process is a directed ribbon-beam etching process;
the contact vias are made of W; and
the mask layer is an antireflective layer.
